# EUROPEAN PATENT APPLICATION

(11) **EP 4 752 354 A1**
(43) Date of publication of application: **03.06.2026**
(21) Application number: 24951492.8
(22) Date of filing: 30.09.2024
(51) Int. Cl.: F02F 5/00

(54) **METHOD FOR MANUFACTURING SLIDING MEMBER, SLIDING MEMBER, AND PISTON RING**

(71) Applicant: Kabushiki Kaisha Riken, Tokyo 102-8202 (JP)
(72) Inventor: Kishimoto, Yugo, Kashiwazaki, Niigata 945-8555 (JP)
(74) Representative: Arnold & Siedsma
(86) International application number: PCT/JP2024/034945
(87) International publication number: WO 2026/069663

(57) **Abstract**

A method for manufacturing a sliding member including a substrate and a film provided to cover at least a part of a surface of the substrate, the method including: (A) a step of obtaining an intermetallic compound containing Cr and a metal element containing at least Si; and (B) a step of forming the film by an arc ion plating method using the intermetallic compound, wherein in the step (B), a bias voltage in a range of from -2 V to -25 V is set in a nitrogen atmosphere. A sliding member including a substrate and a film provided to cover at least a part of a surface of the substrate, wherein the film contains Cr, N, and a metal element containing at least Si, the film has a base portion and dispersed particle portions scattered in the base portion, and a hardness of the film is 1900 HV0.1 or less.

## Description

### Technical Field

The present invention relates to a method for manufacturing a sliding member, a sliding member, and a piston ring.

### Background Art

Sliding members such as piston rings are used in engines of automobiles and the like. A piston ring is mounted in a groove provided on an outer peripheral surface of a piston. Piston rings are required to contribute to, for example, higher performance of engines and reduction in fuel consumption through characteristics such as wear resistance and seizure resistance. Conventionally, various efforts have been made to improve the wear resistance of piston rings.

For example, the invention described in Patent Literature 1 was made to provide a sliding member that is excellent in wear resistance even under harsh conditions in an engine to which direct fuel injection or exhaust gas recirculation (EGR) is applied. In this sliding member, a substrate is covered with a film made of a mixed structure of a crystalline phase and an amorphous phase, which is made of a metal nitride, a metal carbide, or a metal carbonitride.

The invention described in Patent Literature 2 was made to provide a piston ring for an internal combustion engine having both wear resistance and crack resistance and peeling resistance. In this piston ring, a hard film is formed on at least an outer peripheral sliding surface, the hard film being composed of a crystalline phase that includes Cr, N, and Si as constituent elements, has the same crystal structure as CrN, and has Si dissolved in solid solution in its crystal lattice at a ratio of 1% or more and 9.5% or less in terms of atomic ratio.

### Citation List

### Patent Literature

Patent Literature 1: Japanese Unexamined Patent Publication No. 2002-266697
Patent Literature 2: Japanese Unexamined Patent Publication No. 2008-14228

### Summary of Invention

### Technical Problem

A sliding member is required not only to have excellent self-wear resistance but also to have low aggressiveness to a mating material. Therefore, a high-level balance is required in which neither the sliding member nor the mating material wears. Furthermore, in recent years, for the purpose of responding to higher engine output and exhaust gas regulations, for example, an increase in combustion temperature, adoption of low-viscosity lubricating oil, and a reduction in the amount of oil have been progressing. As for FFVs (Flex Fuel Vehicles), those adjusted with a wide range of mixing ratios of gasoline and biofuel are in circulation. Along with this, the operating environment for sliding members is becoming harsher and a boundary lubrication environment year by year, and not only an increase in the amount of wear of the film of the sliding member but also peeling of the film due to an increase in sliding resistance has become a problem.

Therefore, the present invention provides a method for manufacturing a sliding member, a sliding member, and a piston ring that are excellent in peeling resistance even under a harsh environment, have a good balance between wear resistance and aggressiveness to a mating material, and can achieve these at a sufficiently high level.

### Solution to Problem

The present invention includes, for example, the following.
[1] A method for manufacturing a sliding member including a substrate and a film provided so as to cover at least a part of a surface of the substrate, the method including:
   (A) a step of obtaining an intermetallic compound containing Cr and a metal element including at least Si; and
   (B) a step of forming the film by an arc ion plating method using the intermetallic compound,
   wherein in the step (B), a bias voltage in a range of from -2 V to -25 V is set in a nitrogen atmosphere.
[2] A sliding member including:
   a substrate; and
   a film provided to cover at least a part of a surface of the substrate,
   wherein the film contains: Cr, N, and a metal element including at least Si,
   wherein the film includes: a base portion; and dispersed particle portions scattered in the base portion, and
   wherein a hardness of the film is 1900 HV0.1 or less.
[3] The sliding member according to [2], wherein the metal element includes at least one selected from the group consisting of Ti, Al, Mo, V, W, Nb, Mn, Zn, Cu, and Zr.
[4] The sliding member according to [2] or [3], wherein a content of the metal element in the base portion is from 1 at% to 25 at%.
[5] The sliding member according to any one of [2] to [4], wherein a content of the metal element in the dispersed particle portions is greater than a content of the metal element in the base portion.
[6] The sliding member according to any one of [2] to [5], wherein a hardness of the film is from 800 HV0.1 to 1,500 HV0.1.
[7] A piston ring including the sliding member according to any one of [2] to [6].

### Advantageous Effects of Invention

According to the present invention, a method for manufacturing a sliding member, a sliding member, and a piston ring are provided that are excellent in peeling resistance even under a harsh environment, have a good balance between wear resistance and aggressiveness to a mating material, and can achieve these at a sufficiently high level.

### Brief Description of Drawings

Fig. 1 is a schematic cross-sectional view of a sliding member according to an embodiment of the present invention.
Fig. 2 is a schematic diagram of a surface of a film in a sliding member according to an embodiment of the present invention.
Fig. 3 is an analysis result by EPMA of a surface of a piston ring of Example 1.
Fig. 4 is a binarized image of a surface of a piston ring of Example 1.
Fig. 5 is a schematic diagram showing a configuration of a sliding fatigue tester.

### Description of Embodiments

Hereinafter, embodiments of the present invention will be described in detail. The present invention is not limited to the following embodiments.

### (Sliding Member)

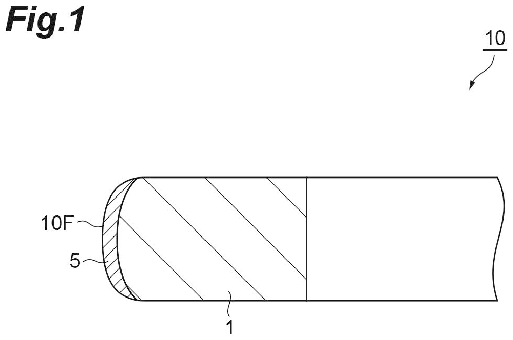

Fig. 1 is a schematic cross-sectional view of a sliding member according to an embodiment of the present invention. A sliding member 10 shown in Fig. 1 includes a substrate 1 and a film 5 provided so as to cover at least a part of a surface of the substrate 1. The film 5 may be provided on an outer peripheral surface of the substrate 1 (a surface corresponding to a sliding surface 10F). The sliding member 10 is, for example, a pressure ring (piston ring) for an internal combustion engine (for example, an automobile engine). The pressure ring is mounted, for example, in a ring groove formed on a side surface of a piston. The pressure ring is a ring that is particularly exposed to an environment with a high thermal load of the engine.

When the sliding member is a piston ring, the piston ring is annular and has, for example, an outer diameter of from 40 mm to 300 mm. The term "annular" as used herein may mean a closed circular shape or a substantially circular shape having an opening. The piston ring may be perfectly circular or elliptical in a plan view. The piston ring is substantially rectangular in cross-section, and the sliding surface may have an outwardly bulging roundness.

The substrate is made of an alloy having heat resistance. Specific examples of the alloy include spring steel and martensitic stainless steel and the like. The substrate may be one on which a nitrided layer is formed on its surface.

The film is made of a Cr-Me-N-based material (Me represents a metal element). The metal element Me includes at least Si from the viewpoint of a better balance among wear resistance, peeling resistance, and aggressiveness to a mating material. The metal element Me may further include, in addition to Si, for example, at least one selected from the group consisting of Ti, Al, Mo, V, W, Nb, Mn, Zn, Cu, and Zr.

The thickness of the film may be, for example, from 5 µm to 70 µm, or from 10 µm to 50 µm. When the thickness of the film is 5 µm or more, the durability of the sliding member tends to be high, while when it is 70 µm or less, high productivity of the film can be ensured.

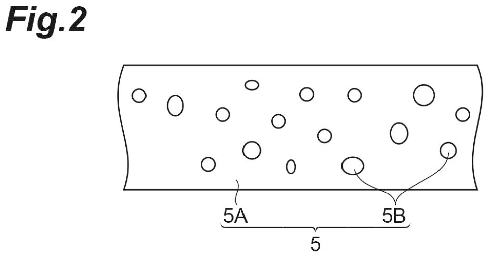

As shown in Fig. 2, the film 5 has a base portion 5A and dispersed particle portions 5B scattered in the base portion 5A. The fact that the film has a base portion and dispersed particle portions can be confirmed from a backscattered electron image obtained by observing the film with a scanning electron microscope (SEM or FE-SEM).

The base portion and the dispersed particle portions are each made of a Cr-Me-N-based material, but the content of each element is different. The content of the metal element in the dispersed particle portions may be greater than the content of the metal element in the base portion from the viewpoint of a better balance among wear resistance, peeling resistance, and aggressiveness to the mating material. Note that the dispersed particle portions containing a metal element such as Si are also referred to as alloy-component dispersed particle portions.

The equivalent circle diameter of the dispersed particle portions is, for example, from 0.1 µm to 10 µm. The equivalent circle diameter of the dispersed particle portions can be measured based on a backscattered electron image obtained by observing the surface of the film with an SEM or the like.

The elemental composition of the base portion and the dispersed particle portions of the sliding member is measured by the following method. That is, first, the film surface formed on the outer peripheral surface of the sliding member is polished with a polishing machine (for example, IS-POLISHER manufactured by Ikegami Seiki Co., Ltd.). Specifically, the grit size is gradually increased from #600, and finally, polishing is performed with a diamond film with a particle size of 0.5 µm to obtain a sample. Then, using the obtained sample, a concentration map of the elements is obtained using an EPMA (for example, JXA-8100 manufactured by JEOL Ltd.). The measurement conditions are: acceleration voltage 15 kV, irradiation current 5.0 × 10⁻⁸ A, beam diameter 0 µm (minimum setting value), scan interval (vertical direction: 0.30 µm, horizontal direction: 0.30 µm), scan time 30 ms/point, and number of scan points (vertical direction: 200 points × horizontal direction: 200 points), to obtain a concentration map (60 µm × 60 µm) for each analyzed element. Note that even if the measurement beam diameter is set to the minimum setting value of the EPMA, the actual beam diameter does not become 0 µm, but becomes a nanometer-order beam diameter. Regarding the elemental amounts of the base portion and the dispersed particle portions, the largest dispersed particle portion (a dispersed particle portion with an equivalent circle diameter of at least 2 µm or more) is selected from the concentration map, a line scan is performed so as to pass through that dispersed particle portion, and the concentration of each element with respect to the scan position is determined as a profile. If a small dispersed particle is scanned, the surrounding base portion is also analyzed, so the elemental concentration of the dispersed particle portion is not a true value but shifts toward the elemental concentration of the base portion, which is not preferable. In the concentration profile of the line scan thus obtained, the baseline of the profile is taken as the average concentration of the base portion, the concentration of the part corresponding to the dispersed particle portion is taken as the maximum concentration of the dispersed particle, and the concentration of the base portion and the concentration of the dispersed particle portion can be compared.

In the sliding member according to an embodiment of the present invention, the film includes Cr, N, and a metal element including at least Si, and has a base portion and dispersed particle portions scattered in the base portion, and a hardness of the film is 1900 HV0.1 or less, whereby the balance among wear resistance, peeling resistance, and aggressiveness to the mating material is excellent. The inventor presumes the reason for this as follows.
<1> The dispersed particles scattered in the base portion of the film of the sliding member include not only Cr but also a metal element such as Si, whereby the dispersed particle portions (alloy-component dispersed particle portions) are strongly bonded to the base portion, so the toughness of the entire film increases, making it less likely to become a starting point of peeling due to sliding resistance, thereby improving peeling resistance.
<2> Because the dispersed particle portions include not only Cr but also other metal elements, a lubricating film called a tribofilm is formed by reaction with lubricating oil during sliding between the film and the mating material, and the lubricating film functions as a protective film, thereby improving wear resistance and reducing aggressiveness to the mating material.
<3> If the hardness of the film is too high, the film has low flexibility and stress tends to concentrate, making cracks more likely to occur, causing the film to peel easily and also making it easier to wear the mating material. However, by the hardness of the film being small to some extent, peeling resistance is improved and aggressiveness to the mating material can be reduced. In addition, although wear resistance generally tends to be insufficient when the hardness of the film is low, because the dispersed particle portions include a metal element such as Si, the wear resistance of the dispersed particle portions themselves is improved.
Due to the above mechanisms, compared to dispersed particle portions of Cr alone that do not include a metal element such as Si, the wear resistance of the entire film can be ensured even if the hardness of the entire film is low, and the toughness of the entire film increases, making peeling of the film less likely to occur and improving peeling resistance. However, the mechanism of the present invention is not limited to the above content.

The content of Cr in the base portion may be 30 at% or more, 35 at% or more, or 40 at% or more from the viewpoint of a better balance among wear resistance, peeling resistance, and aggressiveness to the mating material, and from the same viewpoint, may be 60 at% or less, 55 at% or less, or 50 at% or less. From these viewpoints, the content of Cr in the base portion may be from 30 at% to 60 at%.

The total content of the metal elements in the base portion may be 1 at% or more, 3 at% or more, or 5 at% or more from the viewpoint of a better balance among wear resistance, peeling resistance, and aggressiveness to the mating material, and from the same viewpoint, may be 25 at% or less, 22 at% or less, 20 at% or less, 15 at% or less, 12 at% or less, 10 at% or less, 8 at% or less, 7 at% or less, 6 at% or less, 5 at% or less, 4 at% or less, 3.5 at% or less, or 3 at% or less. From these viewpoints, the total content of the metal elements in the base portion may be from 1 at% to 25 at%, from 1 at% to 20 at%, from 1 at% to 12 at%, from 1 at% to 8 at%, from 1 at% to 5 at%, or from 1 at% to 3 at%.

The content of Si in the base portion may be 1 at% or more, 2 at% or more, or 3 at% or more from the viewpoint of a better balance among wear resistance, peeling resistance, and aggressiveness to the mating material, and from the same viewpoint, may be 8 at% or less, 7 at% or less, 6 at% or less, 5 at% or less, 4 at% or less, 3.5 at% or less, or 3 at% or less. From these viewpoints, the content of Si in the base portion may be from 1 at% to 8 at%, from 1 at% to 5 at%, or from 1 at% to 3.5 at%.

The content of Ti in the base portion may be 0 at% or more, 4 at% or more, or 7 at% or more from the viewpoint of a better balance among wear resistance, peeling resistance, and aggressiveness to the mating material, and from the same viewpoint, may be 25 at% or less, 20 at% or less, or 17 at% or less. From these viewpoints, the content of Ti in the base portion may be from 0 at% to 25 at%.

The total content of Si and Ti in the base portion may be 1 at% or more, 6 at% or more, or 10 at% or more from the viewpoint of a better balance among wear resistance, peeling resistance, and aggressiveness to the mating material, and from the same viewpoint, may be 30 at% or less, 24 at% or less, or 20 at% or less. From these viewpoints, the total content of Si and Ti in the base portion may be from 1 at% to 30 at%.

The content of N in the base portion may be 35 at% or more, 40 at% or more, or 45 at% or more from the viewpoint of a better balance among wear resistance, peeling resistance, and aggressiveness to the mating material, and from the same viewpoint, may be 65 at% or less, 60 at% or less, or 55 at% or less. From these viewpoints, the content of N in the base portion may be from 35 at% to 65 at%.

The content of Cr in the dispersed particle portions may be 40 at% or more, 45 at% or more, or 50 at% or more from the viewpoint of a better balance among wear resistance, peeling resistance, and aggressiveness to the mating material, and from the same viewpoint, may be 80 at% or less, 75 at% or less, or 70 at% or less. From these viewpoints, the content of Cr in the dispersed particle portions may be from 40 at% to 80 at%.

The total content of the metal elements in the dispersed particle portions may be 1 at% or more, 3 at% or more, or 5 at% or more from the viewpoint of a better balance among wear resistance, peeling resistance, and aggressiveness to the mating material, and from the same viewpoint, may be 30 at% or less, 26 at% or less, 24 at% or less, 22 at% or less, 20 at% or less, 15 at% or less, or 10 at% or less. The total content of the metal elements in the dispersed particle portions may be from 1 at% to 30 at%, from 1 at% to 24 at%, from 1 at% to 20 at%, from 1 at% to 15 at%, or from 1 at% to 10 at%.

The content of Si in the dispersed particle portions may be 2 at% or more, 3 at% or more, 4 at% or more, or 5 at% or more from the viewpoint of a better balance among wear resistance, peeling resistance, and aggressiveness to the mating material, and from the same viewpoint, may be 15 at% or less, 13 at% or less, 10 at% or less, 8 at% or less, or 6 at% or less. From these viewpoints, the content of Si in the dispersed particle portions may be from 2 at% to 15 at%, or from 3 at% to 10 at%.

The content of Ti in the dispersed particle portions may be 0 at% or more, 6 at% or more, or 9 at% or more from the viewpoint of a better balance among wear resistance, peeling resistance, and aggressiveness to the mating material, and from the same viewpoint, may be 30 at% or less, 22 at% or less, or 19 at% or less. From these viewpoints, the content of Ti in the dispersed particle portions may be from 0 at% to 30 at%.

The total content of Si and Ti in the dispersed particle portions may be 3 at% or more, 10 at% or more, or 14 at% or more from the viewpoint of a better balance among wear resistance, peeling resistance, and aggressiveness to the mating material, and from the same viewpoint, may be 40 at% or less, 30 at% or less, or 25 at% or less. From these viewpoints, the total content of Si and Ti in the dispersed particle portions may be from 3 at% to 40 at%.

The content of N in the dispersed particle portions may be 10 at% or more, 15 at% or more, or 20 at% or more from the viewpoint of a better balance among wear resistance, peeling resistance, and aggressiveness to the mating material, and from the same viewpoint, may be 50 at% or less, 45 at% or less, or 40 at% or less. From these viewpoints, the content of N in the dispersed particle portions may be from 10 at% to 50 at%.

The difference between the total content of the metal elements in the dispersed particle portions and the total content of the metal elements in the base portion (dispersed particle portions - base portion) may be 0.5 at% or more, 1 at% or more, or 1.5 at% or more from the viewpoint of a better balance among wear resistance, peeling resistance, and aggressiveness to the mating material, and from the same viewpoint, may be 3 at% or less, 2.5 at% or less, or 2 at% or less.

The difference in the Si content between the dispersed particle portions and the base portion (dispersed particle portions - base portion) may be 1 at% or more, 2 at% or more, or 2.5 at% or more from the viewpoint of a better balance among wear resistance, peeling resistance, and aggressiveness to the mating material, and from the same viewpoint, may be 5 at% or less, 4 at% or less, or 3 at% or less.

The area ratio of the dispersed particle portions having an equivalent circle diameter of 0.1 µm or more on the surface of the film may be from 0.5% to 5% from the viewpoint of a better balance among wear resistance, peeling resistance, and aggressiveness to the mating material. When the area ratio of the dispersed particle portions having an equivalent circle diameter of 0.1 µm or more is 0.5% or more, voids can be appropriately provided between the sliding member and the mating material, so the balance among wear resistance, peeling resistance, and aggressiveness to the mating material tends to be better. When the area ratio of the dispersed particle portions having an equivalent circle diameter of 0.1 µm or more is 5% or less, falling off of the dispersed particles can be suppressed, and the balance among wear resistance, peeling resistance, and aggressiveness to the mating material tends to be better. The area ratio of the dispersed particle portions having an equivalent circle diameter of 0.1 µm or more on the surface of the film may be more than 1.0%, and may be 4.5% or less, or 4% or less, from the viewpoint of a better balance among wear resistance, peeling resistance, and aggressiveness to the mating material.

The area ratio of the dispersed particle portions having an equivalent circle diameter of 0.1 µm or more on the surface of the film can be measured by the following method. That is, the surface of the film of the sliding member is polished using a polishing machine (for example, IS-POLISHER manufactured by Ikegami Seiki Co., Ltd.). Specifically, the grit size is gradually increased from #600, and finally, polishing is performed with a diamond film with a particle size of 0.5 µm to obtain a sample. Then, the obtained sample is observed with an FE-SEM (for example, JSM-7100F manufactured by JEOL Ltd.), and a backscattered electron image is obtained at a magnification of 2000x. A region of 45 µm × 62.5 µm is extracted from the obtained backscattered electron image and subjected to binarization processing by image analysis software (for example, A-zo kun manufactured by Asahi Kasei Engineering Corporation). The total area of the dispersed particle portions with an equivalent circle diameter of 0.1 µm or more is measured from the binarized image. The area ratio can be calculated by dividing the total area of the dispersed particle portions with an equivalent circle diameter of 0.1 µm or more by the measurement area (45 µm × 62.5 µm).

The hardness of the film is 1900 HV0.1 or less. When the hardness of the film is 1900 HV0.1 or less, the balance between peeling resistance and aggressiveness to the mating material is excellent. The hardness of the film may be from 800 to 1800 HV0.1, from 800 to 1500 HV0.1, from 900 to 1500 HV0.1, or from 1000 to 1300 HV0.1, from the viewpoint that it can be elastically deformed to an appropriate extent, Hertzian stress generated by sliding is reduced, and excellent peeling resistance is easily achieved. The hardness of the film can be measured based on the method specified in ISO 6507 using a Vickers hardness tester (for example, device name: HM-220, manufactured by Mitutoyo Corporation).

### (Method for Manufacturing a Sliding Member)

Next, a method for manufacturing a sliding member will be described. The manufacturing method of this embodiment includes the following steps.
(a) A step of obtaining an intermetallic compound containing Cr and a metal element that includes at least Si.
(b) A step of forming a film by an arc ion plating method using the intermetallic compound.

The step (a) is a step of obtaining an intermetallic compound of a predetermined shape by mixing and cold forming powder containing Cr and the metal element, and then sintering the mixture by a hot isostatic pressing method (HIP method) or a hot pressing method.

In the step (a), first, a predetermined amount of a metal powder containing Cr and a metal powder containing Si are mixed, with Cr as a main constituent element and a metal element containing at least Si as a sub-constituent element. As the metal powder, in addition to the metal powder containing Cr and the metal powder containing Si, a metal powder containing at least one selected from the group consisting of Ti, Al, Mo, V, W, Nb, Mn, Zn, Cu, and Zr may be used. The metal powder may be one that contains a plurality of metal elements. The method for manufacturing the metal powder is not particularly limited. The metal powder may be a powder composed of substantially only a single element, or may be a powder produced by melting a plurality of components and then powdering the melt. It may also be a powder alloyed in a solid phase state, such as by mechanical alloying.

Next, the mixed metal powder is cold formed into a predetermined shape using a press machine or the like, and then sintered by a hot isostatic pressing method (HIP method) or a hot pressing method to obtain a target material containing an intermetallic compound of a predetermined shape.

The temperature during sintering by the hot isostatic pressing method (HIP method) or the hot pressing method may be, for example, from 900°C to 1300°C, or from 900°C to 1100°C.

The pressure during sintering by the hot isostatic pressing method (HIP method) or the hot pressing method may be, for example, from 100 MPa to 140 MPa.

By adjusting the types of material components, the mixing ratio, and the sintering conditions for obtaining the intermetallic compound, it is possible to adjust the amount of scattering of dispersed particles and the size of the dispersed particle portions during film formation, while dispersing and arranging the dispersed particles in the film. For example, by lowering the sintering pressure when obtaining the intermetallic compound, the formation of intermetallic compounds of metal elements such as Cr and Si in the dispersed particle portions in the film can be suppressed.

The method for manufacturing a sliding member may include a step for cleaning the surface of the substrate before the step (b). For example, it may include a step of performing a cleaning treatment by degreasing or shot blasting. In addition to this, the method for manufacturing a sliding member may include a step of performing bombard cleaning in a chamber.

The formation of the film in the step (b) can be performed by an arc ion plating method. Specifically, the inside of the chamber is set to a nitrogen atmosphere, and the bias voltage is set in a range of from -2 V to -25 V. When the bias voltage for forming the film by the arc ion plating method using the intermetallic compound is from -2 V to -25 V, it is possible to suppress the film from becoming too dense and to relieve the residual stress inside the film. This makes it possible to manufacture a sliding member that is excellent in peeling resistance even under a harsh environment, has a good balance between wear resistance and aggressiveness to a mating material, and can achieve these at a sufficiently high level. The bias voltage may be from -3 V to -15 V, or from -4 V to -10 V, from the viewpoint of a better balance among wear resistance, peeling resistance, and aggressiveness to the mating material of the sliding member.

The nitrogen pressure in the chamber may be from 1 Pa to 10 Pa, from 2 Pa to 8 Pa, or from 4 Pa to 6.5 Pa, from the viewpoint of a better balance among wear resistance, peeling resistance, and aggressiveness to the mating material of the sliding member. The film formation temperature may be, for example, from 300°C to 500°C. The arc current may be from 100 A to 200 A.

Constituent elements ionized from the target material containing the intermetallic compound by arc discharge are deposited on the substrate to which a cathode potential is applied, forming the base portion of the film made of the constituent elements, and at the same time, droplets generated at arc spots on the surface of the intermetallic compound are also released and are dispersed and arranged in the base portion as dispersed particle portions.

### Examples

Hereinafter, the present invention will be described in more detail based on Invention Examples and Comparative Examples. The present invention is not limited to the following Invention Examples.

### (Invention Examples 1 to 14 and Comparative Examples 1 to 9)

### < Film Formation >

JIS SWOSC-V (silicon-chromium steel oil-tempered wire) was used as a substrate for a sliding member (piston ring) and processed into a ring shape. Next, as a pre-preparation for film formation, after degreasing and cleaning the substrate, the ring substrate was placed in an ion plating apparatus. Then, in the chamber, with the chamber atmosphere as nitrogen, a target material (including a metal compound or an intermetallic compound) having the composition shown in Table 1 was ionized under the nitrogen pressure shown in Table 1, the bias voltage shown in Table 1, and a film formation temperature of 400°C, to form a film with a thickness of about 20 µm on the substrate surface. At this time, the arc current was 150 A for Invention Examples 1 to 14 and Comparative Examples 1, 2, 4 to 6, 8, and 9, the arc current was 100 A for Comparative Example 3, and the arc current was 350 A for Comparative Example 7. The intermetallic compound was produced by mixing a predetermined amount of a metal powder containing Cr and a metal powder containing an arbitrary metal element so as to have the target composition shown in Table 1, cold forming the mixture using a press machine, and then sintering the formed body by a hot isostatic pressing method (HIP method) within a range of 900°C to 1300°C and within a range of 100 MPa to 140 MPa.

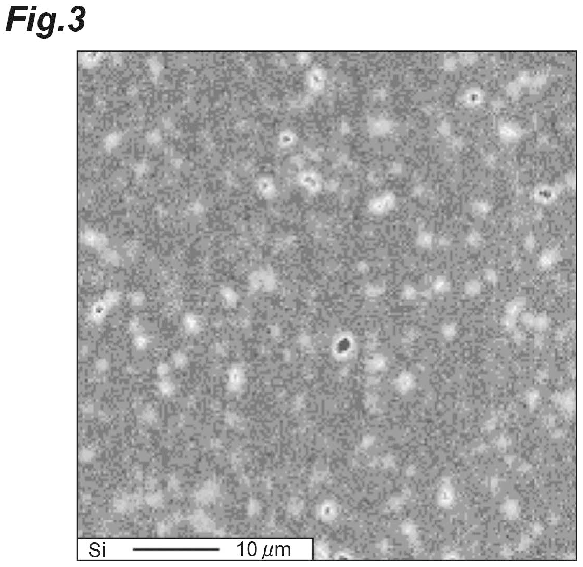

The elemental composition of the base portion and the dispersed particle portions of the produced piston ring was measured by the following method. First, the film surface formed on the outer peripheral surface of the piston ring was polished with a polishing machine (IS-POLISHER manufactured by Ikegami Seiki Co., Ltd.). Specifically, the grit size was gradually increased from #600, and finally, polishing was performed with a diamond film with a particle size of 0.5 µm to obtain a sample. Then, using the obtained sample, a concentration map of the elements was obtained using an EPMA (device name: JXA-8100, manufactured by JEOL Ltd.). The measurement conditions were: acceleration voltage 15 kV, irradiation current 5.0 × 10⁻⁸ A, beam diameter 0 µm (minimum setting value), scan interval (vertical direction: 0.30 µm, horizontal direction: 0.30 µm), scan time 30 ms/point, and number of scan points (vertical direction: 200 points × horizontal direction: 200 points), to obtain a concentration map (60 µm × 60 µm) for each analyzed element. Regarding the elemental amounts of the base portion and the dispersed particle portions, the largest dispersed particle portion was selected from the concentration map, a line scan was performed so as to pass through that dispersed particle portion, and the concentration of each element with respect to the scan position was determined as a profile. In the concentration profile of the line scan thus obtained, the baseline of the profile was taken as the average concentration of the base portion, the concentration of the part corresponding to the dispersed particle portion was taken as the maximum concentration of the dispersed particle, and the concentration of the base portion and the concentration of the dispersed particle portion were compared. An analysis result by EPMA of the surface of the piston ring of Example 1 is shown in Fig. 3. In Fig. 3, the darker the black color, the higher the Si concentration.

**[Table 1]**

| | Target Composition | Film Formation Conditions | | Metal Element in Dispersed Particle Portion | Metal Element Concentration (mass %) | | Area Ratio of Dispersed Particle Portion | Hardness HV (HV0.1) | Evaluation Results | | |
|---|---|---|---|---|---|---|---|---|---|---|---|
| | | Pressure (Pa) | Bias Voltage (V) | | Dispersed Particle Portion | Base Portion | | | Wear Resistance | Aggressi veness to the Mating Material | Peeling Resistance |
| Invention Example 1 | Cr,Si | 4 | -10 | Si | 2.6 | 1.6 | B | 1236 | A | A | A |
| Invention Example 2 | Cr,Si | 4 | -12 | Si | 3.4 | 1.9 | B | 1205 | A | A | A |
| Invention Example 3 | Cr,Si | 5 | -8 | Si | 2.9 | 1.1 | A | 1084 | A | A | A |
| Invention Example 4 | Cr,Si | 5 | -2 | Si | 6.6 | 5.8 | C | 860 | B | A | A |
| Invention Example 5 | Cr,Si | 5.5 | -10 | Si | 5.6 | 3.1 | B | 1167 | A | A | A |
| Invention Example 6 | Cr,Si | 8 | -13 | Si | 8.4 | 4.2 | C | 876 | B | A | A |
| Invention Example 7 | Cr,Si | 2 | *-*15 | Si | 12.1 | 7.5 | C | 1489 | A | B | A |
| Invention Example 8 | Cr, Si, Ti | 4 | -12 | Si, Ti | 13.6 | 10.2 | B | 1280 | A | A | A |
| Invention Example 9 | Cr, Si, Al | 4.5 | -9 | Si, Al | 21.4 | 18.1 | B | 1171 | A | A | A |
| Invention Example 10 | Cr, Si, Al | 2 | *-*15 | Si, Al | 8.1 | 6.4 | C | 1791 | A | B | A |
| Invention Example 11 | Cr, Si. Ti, Al | 3 | *-*15 | Si, Ti, Al | 25.3 | 21.4 | B | 1295 | A | A | A |
| Invention Example 12 | Cr, Si, Al, Mo, V | 7 | -3 | Si, Al, Mo, V | 23.2 | 19.2 | C | 905 | B | A | A |
| Invention Example 13 | Cr, Si, Ti, Al, Mo | 4 | -10 | Si, Ti, Al, Mo | 26.4 | 22.4 | B | 1201 | A | A | A |
| Invention Example 14 | Cr,Si | 3.5 | -25 | Si | 4.8 | 2.8 | A | 1900 | A | B | A |
| Comparative Example 1 | Cr | 5 | -11 | - | 0 | 0 | B | 1121 | | | C |
| Comparative Example 2 | Cr | 2 | -14 | - | 0 | 0 | B | 1447 | C | C | C |
| Comparative Example 3 | Cr | 2 | *-*15 | - | 0 | 0 | A | 1622 | B | C | C |
| Comparative Example 4 | Cr | 3 | -12 | - | 0 | 0 | A | 1250 | C | B | C |
| Comparative Example 5 | Cr | 3 | -30 | - | 0 | 0 | B | 1857 | B | C | C |
| Comparative Example 6 | Cr | 4 | -16 | - | 0 | 0 | B | 1534 | B | C | C |
| Comparative Example 7 | Cr | 6 | -5 | - | 0 | 0 | C | 955 | C | A | B |
| Comparative Example 8 | Cr | 7.5 | -2 | - | 0 | 0 | B | 872 | C | A | B |
| Comparative Example 9 | Cr,Si | 3.5 | -30 | Si | 7.2 | 4.7 | C | 1953 | A | B | B |

### < Film Characteristics >

Table 1 shows the characteristics of the films of the piston rings according to the Examples and Comparative Examples. Each characteristic was measured by the following method.

### (Area Ratio of Dispersed Particle Portions)

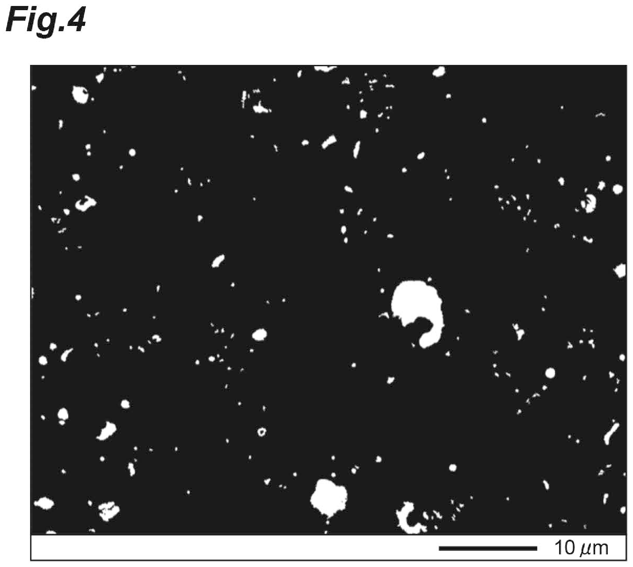

The surface of the film of the produced piston ring was polished using a polishing machine (IS-POLISHER manufactured by Ikegami Seiki Co., Ltd.). Specifically, the grit size was gradually increased from #600, and finally, polishing was performed with a diamond film with a particle size of 0.5 µm to obtain a sample. Then, the obtained sample was observed with an FE-SEM (JSM-7100F manufactured by JEOL Ltd.), and a backscattered electron image was obtained at a magnification of 2000x. A region of 45 µm × 62.5 µm was extracted from the obtained backscattered electron image and subjected to binarization processing by image analysis software (for example, A-zo kun manufactured by Asahi Kasei Engineering Corporation). A binarized image of the surface of the piston ring of Example 1 is shown in Fig. 4. In Fig. 4, the black portions are the base portion, and the white portions are the dispersed particle portions. The total area of the dispersed particle portions with an equivalent circle diameter of 0.1 µm or more was measured from the binarized image. The area ratio of the dispersed particle portions was calculated by dividing the total area of the dispersed particle portions with an equivalent circle diameter of 0.1 µm or more by the measurement area (45 µm × 62.5 µm). The evaluation criteria for the area ratio of dispersed particle portions are as follows.
A: Area ratio is 1% or less.
B: Area ratio is more than 1% and 4% or less.
C: Area ratio is more than 4%.

### (Hardness)

The hardness HV of the film was obtained by performing a hardness test at a test load of 0.98 N based on the method specified in ISO 6507, using a Vickers hardness tester (device name: HM-220, manufactured by Mitutoyo Corporation).

### < Sliding Fatigue Test>

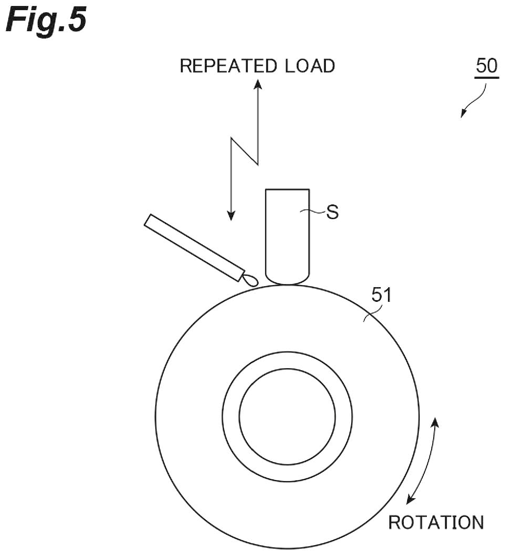

As a wear acceleration test, a sliding fatigue test was performed using a tester with the configuration shown in Fig. 5. A tester 50 shown in Fig. 5 includes a rotating drum 51, a mechanism for bringing a test piece S (a piston ring cut piece) into contact with the surface of the drum 51, a mechanism for applying a repeated load to the test piece S, and a mechanism for supplying lubricating oil to a sliding portion. This allows the test piece to be worn in a relatively short time. The test conditions were as follows.
- Test load: 20 to 80 N, sine curve (50 Hz)
- Mating material (drum): SUJ2 heat-treated material (diameter 80 mm)
- Moving speed: Forward/reverse trapezoidal pattern operation
- Lubricating oil: Base oil (0.1 cc dropped once every 30 seconds)
- Drum surface temperature: 80°C
- Test time: 5 cycles of 2 to 3 minutes per cycle

### < Evaluation >

Table 1 shows the evaluation results of the films of the piston rings according to the Examples and Comparative Examples. For each evaluation result, 20 piston rings were produced for each of the Examples and Comparative Examples, and 20 sliding fatigue tests were performed using these as evaluation targets. The film after the sliding fatigue test was visually observed to evaluate the peeling resistance of the film. In addition, for wear resistance and aggressiveness to the mating material, the wear amount of the film of Comparative Example 1 was evaluated as the wear amount of a conventional CrN film. The evaluation criteria were as follows.

### (Peeling Resistance)

A: Among 20 samples, the rate of peeling occurrence is 40% or less.
B: Among 20 samples, the rate of peeling occurrence is more than 40% and less than 80%.
C: Among 20 samples, the rate of peeling occurrence is 80% or more.

### (Wear Resistance)

Wear amount when the wear amount of a conventional CrN film is taken as 1.0
A: Wear amount is 0.7 or less.
B: Wear amount is more than 0.7 and less than 0.9.
C: Wear amount is 0.9 or more.

### (Aggressiveness to Mating Material)

Wear amount of the mating material (SUJ2 heat-treated material) by a conventional CrN film when taken as 1.0
A: Wear amount is 1.0 or less.
B: Wear amount is more than 1.0 and less than 1.2.
C: Wear amount is 1.2 or more.

### Industrial Applicability

According to the present invention, a piston ring is provided which is provided with a film containing Cr and N, and at least one metal element selected from the group consisting of Si, Ti, Al, Mo, V, and W, wherein the piston ring and a method for manufacturing the same can achieve all of wear resistance, peeling resistance, and aggressiveness to a mating material in a well-balanced manner and at a sufficiently high level.

### Reference Signs List

1... substrate, 5... film, 5A... base portion, 5B... dispersed particle portion, 10... sliding member, 10F... sliding surface.

## Claims

1. A method for manufacturing a sliding member comprising a substrate and a film provided so as to cover at least a part of a surface of the substrate, the method comprising:
(A) a step of obtaining an intermetallic compound comprising Cr and a metal element comprising at least Si; and
(B) a step of forming the film by an arc ion plating method using the intermetallic compound,
wherein in the step (B), a bias voltage in a range of from -2 V to -25 V is set in a nitrogen atmosphere.

2. A sliding member comprising:
a substrate; and
a film provided to cover at least a part of a surface of the substrate,
wherein the film comprises: Cr, N, and a metal element comprising at least Si
wherein the film comprises: a base portion; and dispersed particle portions scattered in the base portion, and
wherein a hardness of the film is 1900 HV0.1 or less.

3. The sliding member according to claim 2, wherein the metal element comprises at least one selected from the group consisting of Ti, Al, Mo, V, W, Nb, Mn, Zn, Cu, and Zr.

4. The sliding member according to claim 2 or 3, wherein a content of the metal element in the base portion is from 1 at% to 25 at%.

5. The sliding member according to claim 2 or 3, wherein a content of the metal element in the dispersed particle portions is greater than a content of the metal element in the base portion.

6. The sliding member according to claim 2 or 3, wherein a hardness of the film is from 800 HV0.1 to 1,500 HV0.1.

7. A piston ring comprising the sliding member according to claim 2 or 3.
